# EUROPEAN PATENT SPECIFICATION

(11) **EP 2 801 781 B1**
(45) Date of publication and mention of the grant of the patent: **01.03.2017**
(21) Application number: 12864655.1
(22) Date of filing: 12.12.2012
(51) Int. Cl.: F28D 15/02, F28D 21/00, F25B 23/00, H01L 23/427

(54) **COOLING DEVICE**
KÜHLSYSTEM
SYSTÈME DE REFROIDISSEMENT

(30) Priority: 04.01.2012 JP 2012000038
(43) Date of publication of application: 12.11.2014
(73) Proprietor: NEC Corporation, Tokyo 108-8001 (JP)
(72) Inventor: MATSUNAGA, Arihiro, Tokyo 1088001 (JP); YOSHIKAWA, Minoru, Tokyo 1088001 (JP); SAKAMOTO, Hitoshi, Tokyo 1088001 (JP); SHOUJIGUCHI, Akira, Tokyo 1088001 (JP); CHIBA, Masaki, Tokyo 1088001 (JP); INABA, Kenichi, Tokyo 1088001 (JP)
(74) Representative: Vossius & Partner Patentanwälte Rechtsanwälte mbB
(86) International application number: PCT/JP2012/007942
(87) International publication number: WO 2013/102974

(56) References cited:
- WO-A1-2011/122332
- WO-A1-2011/122332
- JP-A- 2005 291 645
- JP-A- 2005 291 645
- JP-A- 2011 142 298
- JP-A- 2011 142 298
- JP-A- 2011 216 831
- JP-A- 2011 216 831
- TW-U- M 400 605

## Description

### [Technical field]

The present invention relates to a cooling device and in particular, relates to a cooling device using a phase change of a refrigerant.

### [Background art]

In recent years, in order to improve a processing speed of an electronic equipment, a plurality of central processing units (CPUs) are mounted on a circuit board. The circuit board is installed in an electronic device with a hard disk device or the like in high density.

Generally, when a temperature of a semiconductor device such as a CPU or the like exceeds a predetermined temperature, not only the performance of the semiconductor device cannot be maintained but also the semiconductor device is destroyed in some cases. For this reason, a temperature control using cooling or the like is required and a technology by which the semiconductor device in which the amount of heat generated increases can be efficiently cooled is strongly desired.

Accordingly, a study of the boiling cooling system in which the cooling is performed by using a phase change of a refrigerant is performed. In the boiling cooling system, the refrigerant is boiled by the heat generated by a heating element in an evaporation unit and the vapor of the refrigerant is sent to a condensing unit. Whereby, the heat is conveyed and the cooling is performed.

When described in detail, the vapor of the refrigerant that is produced by vaporizing the refrigerant by the heat of the heating element in the evaporation unit is circulated by using the buoyancy due to the density difference between a gas and a liquid and sent to the condensing unit. When the refrigerant is cooled by the heat exchange with the outside air in the condensing unit, the vapor of the refrigerant (gas-phase refrigerant) is condensed to a liquid and the heat generated by the heating element is dissipated to the outside. Further, the refrigerant obtained by condensing the gas-phase refrigerant flows back to the evaporation unit by gravity.

A cooling system mounted on an electronic circuit board is described in Japanese Patent Application Laid-Open No. 2011-47616.

The above-mentioned cooling system includes a heat receiving jacket which vaporizes the liquid refrigerant by the heat generated by a semiconductor device, a condenser which condenses the refrigerant vapor to a liquid by conducting the heat to the outside, a first pipe (a vapor pipe) which conveys the refrigerant vapor to the condenser from the heat receiving jacket, and a second pipe (a liquid return pipe) which conveys the liquid refrigerant to the heat receiving jacket from the condenser. Further, the condenser includes a pair of headers and a plurality of flow paths having a flat shape between the pair of headers. The vapor pipe and the liquid return pipe are sandwiched between the pair of headers of the condenser and connected to each other.

By using the above-mentioned structure, the refrigerant is circulated in the cooling system by using the phase change in which the refrigerant is vaporized by the heat of the semiconductor device. The vapor of the refrigerant which is conveyed to an upper part of the condenser extending in a vertical direction is condensed to the liquid refrigerant by the heat exchange with the outside. The liquid refrigerant flows to a lower part of the condenser and flows back to the heat receiving jacket.

JP-A-2005291645 discloses a cooling device according to the preamble of claim 1.

### [Brief summary of the invention]

### [Problems to be solved by the invention]

With the increase of the amount of heat generation of the semiconductor device such as a CPU or the like, as an alternative of a heat sink, a request for mounting the cooling device using the boiling cooling system in the electronic equipment such as a server or the like increases. When the cooling device using the boiling cooling system is mounted in the electronic equipment such as the server or the like, with the decrease in size of the electronic equipment, it is necessary to reduce the height of the cooling device using the boiling cooling system and dispose the condensing unit near a heat receiving unit.

However, in the cooling device described in patent document 1, because the vapor pipe is connected to a side surface part of the header of the condenser, it is required that the thickness of the header is greater than the outer diameter of the vapor pipe. In other words, because the minimum thickness of the header is limited, when the height of the cooling device is reduced, the length of a flat pipe for dissipating heat has to be shortened. Therefore, a problem in which a cooling performance decreases occurs.

Further, when the evaporation unit and the condensing unit are closely disposed to reduce the size of the cooling device, the curvature of the vapor pipe becomes large and whereby it becomes difficult to achieve a bending work. Therefore, a problem in which a manufacturing accuracy is reduced and a cost increases occurs. On the other hand, when the narrow vapor pipe is used, a problem in which the internal pressure of the refrigerant increases and whereby the cooling performance decreases occurs.

Thus, when the size of the cooling device described in patent document 1 is reduced, a problem in which the cooling performance decreases occurs.

An object of the present invention is to provide a cooling device which can solve the above-mentioned problem in which the cooling performance decreases when the size of the cooling device is reduced.

### [Means for solving the problems]

The above object is achieved by a cooling device according to claim 1. Claims 2-11 disclose further advantageous embodiments of the invention according to claim 1.

### [Effect of the invention]

By the cooling device of the present invention, the cooling device using the boiling cooling system which has a sufficient cooling performance even when the size of the cooling device is reduced can be obtained.

### [Brief description of the drawings]

Fig. 1 is a perspective view showing a structure of a cooling device according to a first exemplary embodiment of the present invention.
Fig. 2 is a perspective view showing a structure of a cooling device according to a second exemplary embodiment of the present invention.
Fig. 3 is a schematic view for explaining action of a cooling device according to a second exemplary embodiment of the present invention.
Fig. 4 is a perspective view showing a structure of a cooling device according to a third exemplary embodiment of the present invention.
Fig. 5 is a perspective view showing a structure of a cooling device according to a third exemplary embodiment of the present invention.
Fig. 6 is a perspective view showing a structure of a cooling device according to a fourth exemplary embodiment of the present invention.

### [Mode for carrying out the invention]

A preferred mode for carrying out the present invention will be described below by using a drawing. In the exemplary embodiment described below, a technically desirable limitation is included to carry out the present invention. However, this does not limit the scope of the invention.

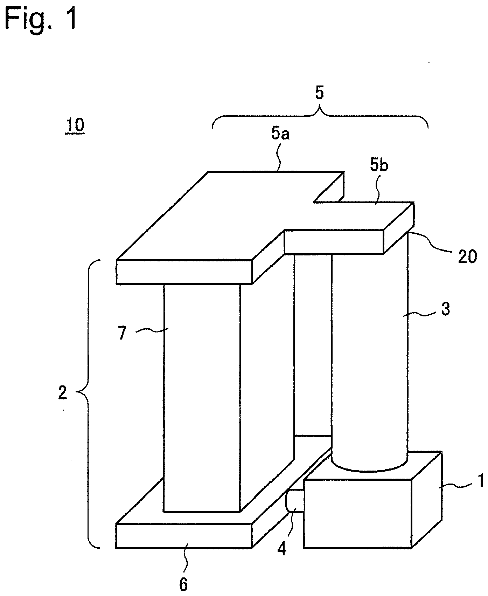

[First exemplary embodiment] First, this exemplary embodiment will be described in detail with reference to the drawing. Fig. 1 is a perspective view showing a structure of a cooling device 10 according to this exemplary embodiment.

[Explanation of the structure] As shown in Fig. 1, the cooling device 10 according to this exemplary embodiment includes an evaporation unit 1, a condensing unit 2, a vapor pipe 3, and a liquid pipe 4.

The evaporation unit 1 has an enclosed structure and stores a refrigerant therein. In the cooling device 10, the air is exhausted by a pump or the like and an internal pressure is equal to a saturated vapor pressure of the refrigerant. In this exemplary embodiment, specifically, HFC (hydro fluorocarbon) or HFE (hydro fluor ether) is used for the refrigerant. However, it is not limited to these fluids. Further, the evaporation unit 1 is set so that a lower surface part of the evaporation unit 1 is thermally connected to the heating element and used. The refrigerant receives heat generated by the heating element and boils.

The heating element is an element which generates heat when it operates. For example, it is a CPU or the like. It is not limited in particular. Further, although the heating element is not shown in a figure, it may be mounted on a substrate. It is desirable that the surface of the heating element which contacts with the evaporation unit 1 is thermally connected to the evaporation unit 1 through a resin having high thermal conductivity or the like such as a heat conduction grease or the like.

The condensing unit 2 is composed of an upper header 5, a lower header 6, and a heat dissipation flow path 7.

The heat dissipation flow path 7 has a shape extending in a vertical direction. An upper end part of the heat dissipation flow path 7 is connected to the upper header 5 and a lower end part thereof is connected to the lower header 6.

The heat dissipation flow path 7 has a hollow tube shape and the refrigerant flows in an internal space. Further, it is desirable that the heat dissipation flow path 7 has a flat shape. However, the shape is not limited to this shape. Further, a material having high thermal conductivity such as copper, aluminum, or the like can be used for the material of the heat dissipation flow path 7. The material is not limited in particular.

The vapor pipe 3 connects an upper part of the evaporation unit 1 and the upper header 5 and conveys the vapor of the refrigerant (gas-phase refrigerant) that is produced by vaporizing the refrigerant in the evaporation unit 1 to the heat dissipation flow path 7 via the upper header 5.

The liquid pipe 4 connects the lower header 6 and a lower part or a side surface part of the evaporation unit 1 and conveys the liquefied refrigerant (liquid-phase refrigerant) obtained by condensing the gas-phase refrigerant in the condensing unit 2 to the evaporation unit 1.

Further, the vapor pipe 3 and the liquid pipe 4 may have a bilayer structure in which an inner layer is a metal layer and an outer layer is a resin layer or a single layer structure in which an inner layer is a metal layer and an outer layer is a metal layer.

The upper header 5 is composed of a flow path header portion 5a connected to the heat dissipation flow path 7 and an upper header extension portion 5b located around the flow path header portion 5a. The lower surface part of the flow path header portion 5a is connected to the heat dissipation flow path 7. Further, a connection port 20 connected to the vapor pipe 3 is provided in the lower surface part of the upper header extension portion 5b. Namely, the lower surface part of the upper header 5 composed of the flow path header portion 5a and the upper header extension portion 5b is connected to the vapor pipe 3 and the heat dissipation flow path 7.

In other words, the lower surface part of the upper header 5 connects the vapor pipe 3 and the heat dissipation flow path 7. Whereby, the upper header 5 conveys the vapor of the refrigerant (gas-phase refrigerant) that is conveyed by the vapor pipe 3 to the heat dissipation flow path 7. Further, an area of the lower surface part of the upper header 5 is determined so as to be greater than a cross-sectional area perpendicular to the vertical direction of the heat dissipation flow path 7 by at least an area of the upper header extension portion 5b.

Further, the vapor pipe 3 connects the upper part of the evaporation unit 1 and the lower surface part of the upper header 5. Therefore, as shown in Fig. 1, a pipe having a shape extending in a straight line shape can be used for the vapor pipe 3. Therefore, a bending work or the like is not required to produce it.

In Fig. 1, an upper surface part of the lower header 6 is connected to the heat dissipation flow path 7 and a side surface part thereof is connected to the liquid pipe 4. When the vapor of the refrigerant flows in the heat dissipation flow path 7, the vapor of the refrigerant is condensed to the liquid. The lower header 6 collects the liquefied refrigerant (liquid-phase refrigerant). The liquefied refrigerant (liquid-phase refrigerant) flows back to the evaporation unit 1 through the liquid pipe 4.

[Explanation of the action and effect] Next, the action and effect of this exemplary embodiment will be described.

The evaporation unit 1 is made of a material having high thermal conductivity and thermally connected to the heating element through a heat conduction grease or the like. Therefore, the heat generated by the heating element is conducted to the refrigerant provided inside the evaporation unit 1 through the evaporation unit 1.

The refrigerant receives the heat generated by the heating element and boils. The vapor of the refrigerant (gas-phase refrigerant) that is generated when the refrigerant provided in a closed space of the evaporation unit 1 boils flows to the upper header 5 through the vapor pipe 3 by buoyancy due to the density difference between the gas and the liquid.

The vapor of the refrigerant (gas-phase refrigerant) that is conveyed to the upper header 5 flows the heat dissipation flow path 7 and whereby, the heat exchange with the outside air is performed. When the heat dissipation flow path 7 is cooled, the vapor of the refrigerant (gas-phase refrigerant) that flows inside the heat dissipation flow path 7 is cooled and condensed to a liquid. The liquefied refrigerant (liquid-phase refrigerant) falls to the lower part of the heat dissipation flow path 7 by the gravity and flows back to the evaporation unit 1 through the liquid pipe 4. The refrigerant boils by the heat generated by the heating element in the evaporation unit 1 again and a cooling cycle is repeated.

Thus, the refrigerant provided inside the evaporation unit 1 changes from the liquid to the gas by the heat generated by the heating element and when it flows in the heat dissipation flow path 7, it is cooled and the gas is condensed to the liquid again. Namely, the phase of the refrigerant is repeatedly changed from the liquid phase to the gas phase and from the gas phase to the liquid phase and whereby, the heat generated by the heating element is dissipated through the heat dissipation flow path 7.

When an amount of heat generation that is generated by the heating element is large, in order to cool the heating element, much refrigerant is required. However, when the liquid vaporizes, its volume increases by more than several hundred times. Therefore, when the refrigerant boils and vaporizes by the heat generated by the heating element, the internal pressure of the evaporation unit 1 and the vapor pipe 3 in which the vapor of the refrigerant (gas-phase refrigerant) flows increases.

When the internal pressure of the evaporation unit 1 increases, not only the evaporation unit 1 deforms but also a problem in which a cooling performance decreases occurs because the boiling point of the refrigerant increases. Accordingly, in this exemplary embodiment, the cross-sectional area of the vapor pipe 3 is made greater than that of the liquid pipe 4 and the volume of the evaporation unit 1 and the volume of the vapor pipe 3 are increased. Whereby, the internal pressure increase is avoided.

However, in the structure described in patent document 1, the side surface part of the upper header is connected to the vapor pipe. Therefore, the thickness of the upper header has to be at least greater than the outer diameter of the vapor pipe. As a result, when the height of the cooling device is reduced, because the thickness of the upper header cannot be reduced, the length of the flat pipe has to be shortened. Accordingly, a problem in which the cooling performance decreases occurs.

In contrast, the upper header 5 of the cooling device 10 according to this exemplary embodiment is connected to the vapor pipe 3 at the connection port 20 disposed in the lower surface part of an extension header unit 5b. In other words, because the side surface part of the upper header 5 is not connected to the vapor pipe 3, the thickness in the vertical direction can be reduced.

In the cooling device 10, it is not necessary to increase the thickness of the upper header 5 in order to avoid the decrease in cooling performance due to rapid increase of the volume of the refrigerant when the phase of the refrigerant is changed from the liquid phase to the gas phase. As a result, the height of the cooling device 10 can be reduced. Namely, by the cooling device 10 according to this exemplary embodiment, the cooling device 10 using the boiling cooling system which has a sufficient cooling performance even when the size of the cooling device 10 is reduced can be obtained.

In other words, when the mounting height of the cooling device 10 is limited, by reducing the thickness of the upper header 5, the length of the heat dissipation flow path 7 can be made long. Therefore, the cooling performance can be further improved.

Further, a pipe having a straight line shape can be used for the vapor pipe 3 which connects the upper part of the evaporation unit 1 and the lower surface part of the upper header 5. Therefore, it is not necessary to deform the vapor pipe 3 having a large cross-sectional area and the cost for the manufacturing process can be reduced.

Further, because a bending work is not required to produce the vapor pipe 3, the condensing unit 2 can be disposed near the evaporation unit 1 and the size of the cooling device 10 can be further reduced.

When the vapor pipe 3 and the liquid pipe 4 have a bilayer structure in which an inner layer is a metal layer and an outer layer is a resin layer, the following effect is obtained. Namely, even when the vapor of the refrigerant (gas-phase refrigerant) or the high temperature refrigerant flows inside the vapor pipe 3 and the liquid pipe 4, because the inner layer is a resin layer, generation of uncondensed gas due to reaction between the refrigerant and the resin layer can be prevented. As a result, the decrease in cooling performance due to the increase of the internal pressure inside a cooler caused by the generation of the uncondensed gas can be prevented.

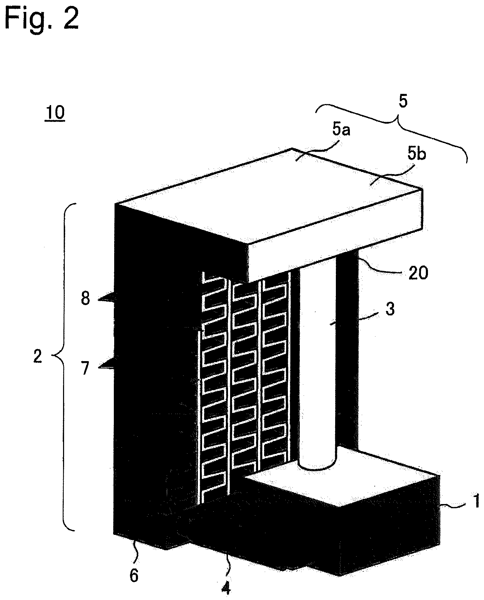

[Second exemplary embodiment] Next, a second exemplary embodiment will be described in detail with reference to Fig. 2. Fig. 2 is a perspective view of the cooling device 10 according to this exemplary embodiment.

[Explanation of the structure] The cooling device 10 according to this exemplary embodiment has a structure in which the cross-sectional area of the upper header extension portion 5b is greater than the cross-sectional area of the vapor pipe 3. The cross-sectional area of the upper header extension portion 5b is a cross-sectional area perpendicular to a direction from the connection port 20 connected to the vapor pipe 3 toward the flow path header 5a. This is a difference between the cooling device 10 according to the second exemplary embodiment and the cooling device 10 according to the first exemplary embodiment. Besides the above-mentioned difference, the structure and the connection relationship of the cooling device 10 according to the second exemplary embodiment are the same as those of the cooling device 10 according to the first exemplary embodiment and the cooling device 10 according to the second exemplary embodiment includes the evaporation unit 1, the condensing unit 2, the vapor pipe 3, and the liquid pipe 4.

The evaporation unit 1 has an enclosed structure and stores the refrigerant therein. In the cooling device 10, the internal pressure is kept equal to a saturated vapor pressure in a state in which the inside thereof is decompressed by a pump or the like. Further, the lower surface part of the evaporation unit 1 is thermally connected to the heating element when the evaporation unit 1 is used. Therefore, the refrigerant receives the heat generated by the heating element and boils.

The heat dissipation flow path 7 has a shape extending in the vertical direction. The upper end part of the heat dissipation flow path 7 is connected to the upper header 5 and the lower end part thereof is connected to the lower header 6. The vapor pipe 3 connects the upper part of the evaporation unit 1 and the upper header 5 and conveys the vapor of the refrigerant (gas-phase refrigerant) that is produced by vaporizing the refrigerant in the evaporation unit 1 to the heat dissipation flow path 7 via the upper header. The liquid pipe 4 connects the lower header 6 and the lower part of the evaporation unit 1 and conveys the liquefied refrigerant (liquid-phase refrigerant) obtained by condensing the gas-phase refrigerant in the condensing unit 2 to the evaporation unit 1.

The upper header 5 is composed of the flow path header portion 5a connected to the heat dissipation flow path 7 and the upper header extension portion 5b located around the flow path header portion 5a. The lower surface part of the flow path header portion 5a is connected to the heat dissipation flow path 7. Further, the connection port 20 connected to the vapor pipe 3 is provided in the lower surface part of the upper header extension portion 5b. Namely, the lower surface part of the upper header 5 composed of the flow path header portion 5a and the upper header extension portion 5b is connected to the vapor pipe 3 and the heat dissipation flow path 7. The upper header 5 conveys the vapor of the refrigerant (gas-phase refrigerant) that is conveyed by the vapor pipe 3 to the heat dissipation flow path 7.

As shown in Fig. 2, the cooling device 10 according to this exemplary embodiment has a structure in which a cross-sectional area perpendicular to a direction from the connection port 20 of the upper header extension portion 5b toward the flow path header 5a is greater than the cross-sectional area perpendicular to a vertical direction of the vapor pipe 3. Further, the arrangement of the vapor pipe 3 is not limited in particular.

[Explanation of the action and effect] Next, the action and effect of this exemplary embodiment will be described.

The refrigerant provided in the evaporation unit 1 receives the heat generated by the heating element and boils. The vapor of the refrigerant that is generated when the refrigerant boils is conveyed to the upper header 5 through the vapor pipe 3 by buoyancy due to the density difference between the gas and the liquid.

The vapor of the refrigerant (gas-phase refrigerant) that is conveyed to the upper header 5 flows in the heat dissipation flow path 7 and whereby, the heat exchange with the outside air is performed. When the heat dissipation flow path 7 is cooled, the vapor of the refrigerant (gas-phase refrigerant) that flows inside the heat dissipation flow path 7 is cooled and condensed to the liquid. The liquefied refrigerant (liquid-phase refrigerant) falls to the lower part of the heat dissipation flow path 7 by the gravity and flows back to the evaporation unit 1. The refrigerant boils by the heat generated by the heating element in the evaporation unit 1 again and the cooling cycle is repeated.

In other words, the refrigerant provided inside the evaporation unit 1 changes from the liquid to the gas by the heat generated by the heating element and when it flows in the heat dissipation flow path 7, it is cooled and the gas is condensed to the liquid again. Namely, the phase of the refrigerant is repeatedly changed from the liquid phase to the gas phase and from the gas phase to the liquid phase and whereby, the heat generated by the heating element is dissipated through the heat dissipation flow path 7.

The cross-sectional area perpendicular to a direction from the connection port 20 of the upper header extension portion 5b according to this exemplary embodiment toward the flow path header 5a is greater than the cross-sectional area perpendicular to a vertical direction of the vapor pipe 3. By using the above-mentioned structure, the cooling device 10 can reduce a pressure loss of the vapor of the refrigerant (gas-phase refrigerant) and improve the cooling performance in the evaporation unit 1.

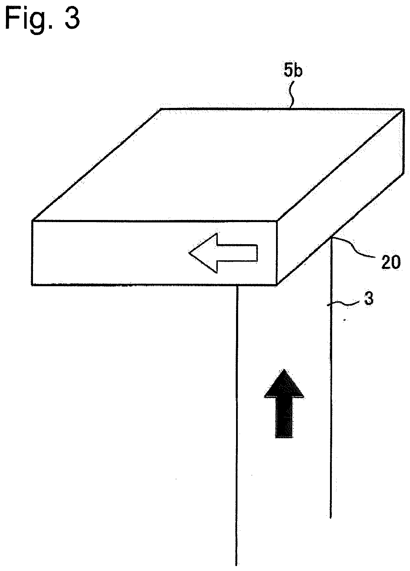

Explanation will be made in detail by using Fig. 3. The vapor of the refrigerant (gas-phase refrigerant) generated when the refrigerant boils by the heat of the heating element in the evaporation unit 1 flows in a vertical upper direction through the vapor pipe 3. The vapor pipe 3 is connected to the lower surface part of the upper header extension portion 5b. Therefore, a flow direction of the vapor of the refrigerant (gas-phase refrigerant) changes from the vertical upper direction to a horizontal direction at a connection point between the vapor pipe 3 and the upper header extension portion 5b.

Here, it is assumed that the cross-sectional area perpendicular to a direction from the connection port 20 of the upper header extension portion 5b toward the flow path header 5a is equal to or smaller than the cross-sectional area perpendicular to a vertical direction of the vapor pipe 3. In this case, it is estimated that the vapor of the refrigerant (gas-phase refrigerant) flows in the upper header extension portion 5b at a speed that is equal to or faster than a speed at which it flows in the vertical upper direction in the vapor pipe 3.

However, the flow direction of the vapor of the refrigerant (gas-phase refrigerant) is changed from the vertical upper direction to the horizontal direction at the connection point between the vapor pipe 3 and the upper header extension portion 5b. Therefore, when the flow direction of the vapor of the refrigerant (gas-phase refrigerant) is changed while keeping the speed of flow constant, a pressure loss occurs at the connection point between the vapor pipe 3 and the upper header extension portion 5b and the cooling performance decreases.

In contrast, the cooling device 10 according to this exemplary embodiment has a structure in which the cross-sectional area perpendicular to a direction from the connection port 20 of the upper header extension portion 5b toward the flow path header 5a is greater than the cross-sectional area perpendicular to a vertical direction of the vapor pipe 3.

Because the cooling device 10 according to this exemplary embodiment has the above-mentioned structure, the speed of flow of the vapor of the refrigerant (gas-phase refrigerant) that flows in the upper header extension portion 5b decreases. Therefore, the pressure loss that occurs when the flow direction of the vapor of the refrigerant (gas-phase refrigerant) is changed from the vertical upper direction in which the vapor of the refrigerant flows in the vapor pipe 3 to the horizontal direction in which it flows in the upper header extension portion 5b at a connection point between the vapor pipe 3 and the upper header extension portion 5b can be reduced. As a result, the cooling performance of the cooling device 10 can be further improved.

Namely, when the flow direction of the vapor of the refrigerant (gas-phase refrigerant) is changed from the vertical upper direction to the horizontal direction at the connection point between the vapor pipe 3 and the upper header extension portion 5b, the flow speed is reduced. Therefore, occurrence of the pressure loss can be prevented.

When the width of the upper header extension portion 5b in the direction from the connection port 20 toward the flow path header 5a and the width thereof in the vertical direction are at least greater than the outer diameter of the vapor pipe 3, the widths of the upper header extension portion 5b in those directions may be smaller than the widths of the flow path header portion in those directions, respectively.

Further, the width of the upper header extension portion 5b in the direction from the connection port 20 toward the flow path header 5a and the width of the upper header extension portion 5b in the vertical direction are approximately equal to the widths of the flow path header portion 5a in those directions, respectively, the upper header extension portion 5b and the flow path header portion 5a can be manufactured in the same process. Therefore, the manufacturing cost can be suppressed.

It is desirable that the length of the upper header extension portion 5b in the direction from the connection port 20 toward the flow path header 5a is smaller than the length of the vapor pipe 3 in the vertical direction.

In the vapor pipe 3 extending in the vertical direction, the refrigerant vapor (gas-phase refrigerant) receives a buoyancy force continuously. On the other hand, in the upper header extension portion 5b, the refrigerant vapor moves in the horizontal direction. Therefore, it does not receive the buoyancy force and loses the energy by friction with the wall continuously.

Therefore, when the length of the upper header extension portion 5b in the direction from the connection port 20 toward the flow path header 5a is smaller than the length of the vapor pipe 3 in the vertical direction, the influence on the cooling performance is small.

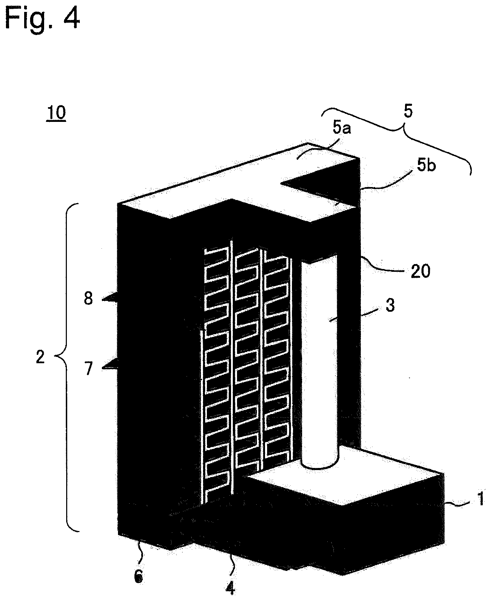

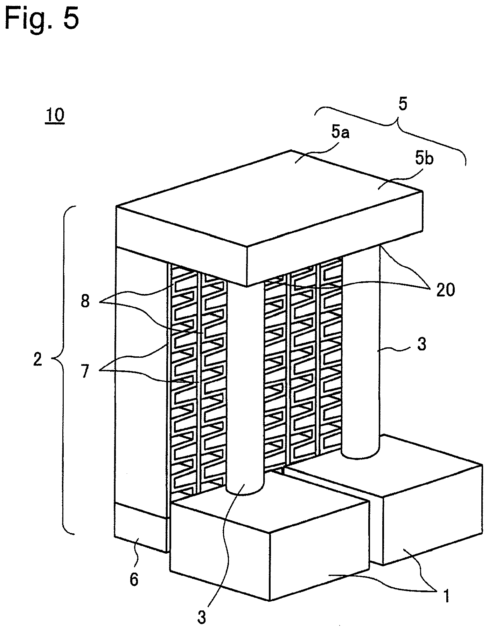

[Third exemplary embodiment] Next, a third exemplary embodiment will be described in detail by using Figs. 4 and 5. Figs. 4 and 5 are perspective views showing a structure of the cooling device 10 according to this exemplary embodiment.

[Explanation of the structure] The condensing unit 2 of the cooling device 10 according to this exemplary embodiment is composed of a plurality of the heat dissipation flow paths 7 and the vapor pipe 3 is disposed in a direction perpendicular to the direction in which a plurality of the heat dissipation flow paths 7 are disposed in parallel. This is a difference between the cooling device 10 according to the third exemplary embodiment and the cooling device 10 according to the first exemplary embodiment. Besides the above-mentioned difference, the structure and the connection relationship of the cooling device 10 according to the third exemplary embodiment are the same as those of the cooling device 10 according to the first exemplary embodiment and the cooling device 10 according to the third exemplary embodiment includes the evaporation unit 1, the condensing unit 2, the vapor pipe 3, and the liquid pipe 4.

The evaporation unit 1 has an enclosed structure and stores the refrigerant therein. In the cooling device 10, the air is exhausted by a pump or the like and the internal pressure is equal to the saturated vapor pressure of the refrigerant. Further, the evaporation unit 1 is set so that the lower surface part of the evaporation unit 1 is thermally connected to the heating element and used. The refrigerant receives the heat generated by the heating element and boils.

The condensing unit 2 according to this exemplary embodiment is composed of a plurality of the heat dissipation flow paths 7 and a heat dissipation fin 8 is provided in between a plurality of the heat dissipation flow paths 7. The heat dissipation fin 8 is disposed in between the adjacent heat dissipation flow paths 7 and thermally connected to the adjacent heat dissipation flow paths 7.

Further, the heat dissipation flow path 7 has a shape extending in the vertical direction. The upper end part of the heat dissipation flow path 7 is connected to the upper header 5 and the lower end part thereof is connected to the lower header 6. The vapor pipe 3 connects the upper part of the evaporation unit 1 and the upper header 5 and conveys the vapor of the refrigerant (gas-phase refrigerant) that is produced by vaporizing the refrigerant in the evaporation unit 1 to the heat dissipation flow path 7 via the upper header 5. The liquid pipe 4 connects the lower header 6 and the lower part of the evaporation unit 1 and conveys the liquefied refrigerant (liquid-phase refrigerant) obtained by condensing the gas-phase refrigerant in the condensing unit 2 to the evaporation unit 1.

The upper header 5 is composed of the flow path header portion 5a connected to the heat dissipation flow path 7 and the upper header extension portion 5b located around the flow path header portion 5a. The lower surface part of the flow path header portion 5a is connected to the heat dissipation flow path 7. Further, the connection port 20 connected to the vapor pipe 3 is provided in the lower surface part of the upper header extension portion 5b. Namely, the lower surface part of the upper header 5 composed of the flow path header portion 5a and the upper header extension portion 5b is connected to the vapor pipe 3 and the heat dissipation flow path 7. The upper header 5 conveys the vapor of the refrigerant (gas-phase refrigerant) that is conveyed through the vapor pipe 3 to the heat dissipation flow path 7.

In the condensing unit 2 according to this exemplary embodiment, a plurality of the heat dissipation flow paths 7 are provided. As shown in Fig. 4, a plurality of the heat dissipation flow paths 7 are disposed in parallel and connected to the flow path header 5a.

The vapor pipe 3 is disposed in a direction perpendicular to the direction in which a plurality of the heat dissipation flow paths 7 are disposed in parallel. In other words, the vapor pipe 3 is disposed at a position facing the condensing unit 2. When a plurality of heating elements exist or when a large amount of heat is generated by the heating element, as shown in Fig. 5, a plurality of the evaporation units 1 may be connected to the upper header extension portion 5b by using a plurality of the vapor pipes 3.

[Explanation of the action and effect] Next, the action and effect of this exemplary embodiment will be described.

The refrigerant provided in the evaporation unit 1 receives the heat generated by the heating element and boils. The vapor of the refrigerant (gas-phase refrigerant) that is generated when the refrigerant boils is conveyed to the upper header 5 through the vapor pipe 3 by buoyancy due to the density difference between the gas and the liquid.

The vapor of the refrigerant (gas-phase refrigerant) that is conveyed to the upper header 5 flows in the heat dissipation flow path 7 and whereby, the heat exchange with the outside air is performed. When the heat dissipation flow path 7 is cooled, the vapor of the refrigerant (gas-phase refrigerant) that flows inside the heat dissipation flow path 7 is cooled and condensed to the liquid. The liquefied refrigerant (liquid-phase refrigerant) falls to the lower part of the heat dissipation flow path 7 by the gravity and flows back to the evaporation unit 1. The refrigerant boils by the heat generated by the heating element in the evaporation unit 1 again and the cooling cycle is repeated.

In other words, the refrigerant provided inside the evaporation unit 1 changes from the liquid to the gas by the heat generated by the heating element and when it flows in the heat dissipation flow path 7, it is cooled and the gas is condensed to the liquid again. Namely, the phase of the refrigerant is repeatedly changed from the liquid phase to the gas phase and from the gas phase to the liquid phase and whereby, the heat generated by the heating element is dissipated through the heat dissipation flow path 7.

The condensing unit 2 according to this exemplary embodiment includes a plurality of the heat dissipation flow paths 7. The heat dissipation fin 8 is disposed in between a plurality of the adjacent heat dissipation flow paths 7. By providing the heat dissipation fin 8, a surface area of the heat dissipation flow path 7 is increased. Therefore, the cooling performance of the refrigerant can be improved because the heat exchange with outside air is promoted.

Further, when a plurality of the heat dissipation flow paths 7 are disposed in parallel, an area required to mount the cooling device 10 is at least equal to an area corresponding to a sum of the widths of a plurality of the heat dissipation flow paths 7. The vapor pipe 3 according to this exemplary embodiment is disposed in a direction perpendicular to the direction in which a plurality of the heat dissipation flow paths 7 are disposed in parallel.

By using the above-mentioned structure, even when the vapor pipe 3 is disposed, it is not necessary to further increase the width of the face facing the vapor pipe 3 of the cooling device 10. Therefore, the size of the cooling device 10 can be reduced. Further, as shown in Fig. 5, by disposing a plurality of the vapor pipes 3 in a direction perpendicular to the direction in which a plurality of the heat dissipation flow paths 7 are disposed in parallel, the cooling performance can be improved without increasing the width of the area required to mount the cooling device 10.

Further, as shown in Fig. 2, in a structure in which the vapor pipe 3 is disposed in a direction perpendicular to the direction in which a plurality of the heat dissipation flow paths 7 are disposed in parallel, the upper header extension portion 5b may have a shape in which the upper header extension portion 5b is extended in the direction toward the vapor pipe 3 so as to form a roof that overhangs the vapor pipe 3.

By using the above-mentioned structure like the second exemplary embodiment, a structure in which the cross-sectional area perpendicular to the direction from the connection port 20 of the upper header extension portion 5b toward the flow path header 5a is greater than the cross-sectional area perpendicular to the vertical direction of the vapor pipe 3 is used. Whereby, the pressure loss of the vapor of the refrigerant (gas-phase refrigerant) can be reduced and the cooling performance in the evaporation unit 1 can be improved.

The cooling device 10 according to this exemplary embodiment can have not only the above-mentioned action and effect but also a duct effect. When described in detail, the upper header extension portion 5b is extended in the direction toward the vapor pipe 3 so as to form an overhanging roof. Whereby, the upper header extension portion 5b can prevent the wind for cooling the heat dissipation flow path 7 from flowing upward and control the flow direction of the wind. As a result, the heat dissipation flow path 7 can be cooled by the cooling wind flowing in the vertical direction. Therefore, the pressure loss of the cooling wind can be reduced and the efficient cooling can be realized.

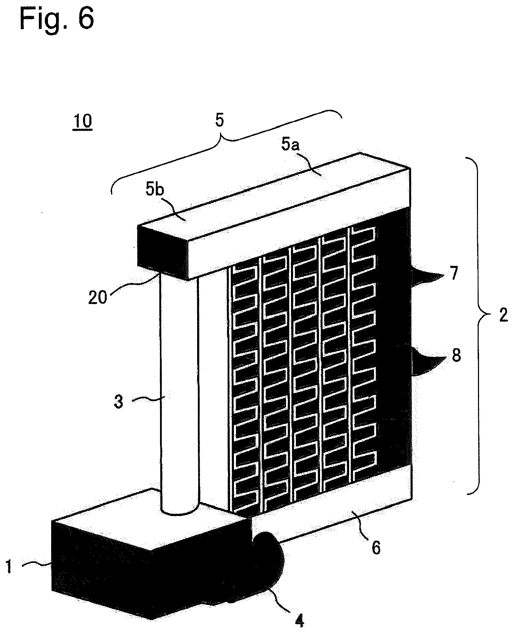

[Fourth exemplary embodiment] Next, a fourth exemplary embodiment will be described in detail with reference to Fig. 6. Fig. 6 is a perspective view of the cooling device 10 according to this exemplary embodiment.

[Explanation of the structure] The condensing unit 2 of the cooling device 10 according to this exemplary embodiment has a structure in which a plurality of the heat dissipation flow paths 7 are disposed in parallel. The vapor pipe 3 is disposed in line approximately parallel to the direction in which a plurality of the heat dissipation flow paths 7 are disposed in parallel. This is a difference between the cooling device 10 according to the fourth exemplary embodiment and the cooling device 10 according to the first exemplary embodiment. Besides the above-mentioned difference, the structure and the connection relationship of the cooling device 10 according to the fourth exemplary embodiment are the same as those of the cooling device 10 according to the first exemplary embodiment and the cooling device 10 according to the fourth exemplary embodiment includes the evaporation unit 1, the condensing unit 2, the vapor pipe 3, and the liquid pipe 4.

The evaporation unit 1 has an enclosed structure and stores the refrigerant therein. In the cooling device 10, the air is exhausted by a pump or the like and the internal pressure is equal to the saturated vapor pressure of the refrigerant. Further, the evaporation unit 1 is set so that the lower surface part of the evaporation unit 1 is thermally connected to the heating element and used. The refrigerant receives heat generated by the heating element and boils.

The condensing unit 2 according to this exemplary embodiment is composed of a plurality of the heat dissipation flow paths 7 and the heat dissipation fin 8 is provided in between a plurality of the heat dissipation flow paths 7. The heat dissipation fin 8 is disposed in between the adjacent heat dissipation flow paths 7 and thermally connected to the adjacent heat dissipation flow paths 7.

Further, the heat dissipation flow path 7 has a shape extending in the vertical direction. The upper end part of the heat dissipation flow path 7 is connected to the upper header 5 and the lower end part thereof is connected to the lower header 6. The vapor pipe 3 connects the upper part of the evaporation unit 1 and the upper header 5 and conveys the vapor of the refrigerant (gas-phase refrigerant) that is produced by vaporizing the refrigerant in the evaporation unit 1 to the heat dissipation flow path 7 via the upper header 5. The liquid pipe 4 connects the lower header 6 and the lower part of the evaporation unit 1 and conveys the liquefied refrigerant (liquid-phase refrigerant) obtained by condensing the gas-phase refrigerant in the condensing unit 2 to the evaporation unit 1.

The upper header 5 is composed of the flow path header portion 5a connected to the heat dissipation flow path 7 and the upper header extension portion 5b located around the flow path header portion 5a. The lower surface part of the flow path header portion 5a is connected to the heat dissipation flow path 7. Further, the connection port 20 connected to the vapor pipe 3 is provided in the lower surface part of the upper header extension portion 5b. Namely, the lower surface part of the upper header 5 composed of the flow path header portion 5a and the upper header extension portion 5b is connected to the vapor pipe 3 and the heat dissipation flow path 7. The upper header 5 conveys the vapor of the refrigerant (gas-phase refrigerant) that is conveyed through the vapor pipe 3 to the heat dissipation flow path 7.

As shown in Fig. 6, in the cooling device 10 according to this exemplary embodiment, a plurality of the heat dissipation flow paths 7 provided in the condensing unit 2 are disposed in parallel. The vapor pipe 3 is disposed in line approximately parallel to the direction in which a plurality of the heat dissipation flow paths 7 are disposed in parallel and connected to the upper header extension portion 5b. In other words, the vapor pipe 3 is disposed on an extension line in a direction in which a plurality of the heat dissipation flow paths 7 are disposed in parallel.

[Explanation of the action and effect] Next, the action and effect of this exemplary embodiment will be described.

The refrigerant provided in the evaporation unit 1 receives the heat generated by the heating element and boils. The vapor of the refrigerant (gas-phase refrigerant) that is generated when the refrigerant boils is conveyed to the upper header 5 through the vapor pipe 3 by buoyancy due to the density difference between the gas and the liquid.

The vapor of the refrigerant (gas-phase refrigerant) that is conveyed to the upper header 5 flows in the heat dissipation flow path 7 and whereby, the heat exchange with the outside air is performed. When the heat dissipation flow path 7 is cooled, the vapor of the refrigerant (gas-phase refrigerant) that flows inside the heat dissipation flow path 7 is cooled and condensed to the liquid. The liquefied refrigerant (liquid-phase refrigerant) falls to the lower part of the heat dissipation flow path 7 by the gravity and flows back to the evaporation unit 1. The refrigerant boils by the heat generated by the heating element in the evaporation unit 1 again and the cooling cycle is repeated.

In other words, the refrigerant provided inside the evaporation unit 1 changes from the liquid to the gas by the heat generated by the heating element and when it flows in the heat dissipation flow path 7, it is cooled and the gas is condensed to the liquid again. Namely, the phase of the refrigerant is repeatedly changed from the liquid phase to the gas phase and from the gas phase to the liquid phase and whereby, the heat generated by the heating element is dissipated through the heat dissipation flow path 7.

The condensing unit 2 according to this exemplary embodiment includes a plurality of the heat dissipation flow paths 7. The heat dissipation fin 8 is disposed in between a plurality of the adjacent heat dissipation flow paths 7. By providing the heat dissipation fin 8, a surface area of the heat dissipation flow path 7 is increased. Therefore, the cooling performance of the refrigerant can be improved because the heat exchange with outside air is promoted.

As shown in Fig. 6, the vapor pipe 3 according to this exemplary embodiment is disposed in line approximately parallel to the direction in which a plurality of the heat dissipation flow paths 7 provided in the condensing unit 2 are disposed in parallel. In other words, the vapor pipe 3 is disposed on an extension line in a direction in which a plurality of the heat dissipation flow paths 7 are disposed in parallel.

Therefore, because the flow of the cooling wind flowing in the direction perpendicular to the direction in which a plurality of the heat dissipation flow paths 7 are disposed in parallel is not disturbed by the vapor pipe 3, the heat dissipation flow path 7 can be cooled efficiently. As a result, the cooling efficiency of the cooling device 10 can be further improved.

This application claims priority from Japanese Patent Application No. 2012-000038 filed on January 4, 2012, the disclosure of which is hereby incorporated by reference in its entirety.

The invention of the present application has been described above with reference to the exemplary embodiment. However, the invention of the present application is not limited to the above mentioned exemplary embodiment. Various changes in the configuration or details of the invention of the present application that can be understood by those skilled in the art can be made without departing from the scope of the invention of the present application.

### [Description of symbol]

- 1: evaporation unit
- 2: condensing unit
- 3: vapor pipe
- 4: liquid pipe
- 5: upper header
- 5a: flow path header portion
- 5b: upper header extension portion
- 6: lower header
- 7: heat dissipation flow path
- 8: heat dissipation fin
- 10: cooling device
- 20: connection port

## Claims

1. A cooling device comprising :
an evaporation unit (1) which stores refrigerant,
a condensing unit (2)
which condenses a gas-phase refrigerant produced by 5 vaporizing the refrigerant in the evaporation unit to a liquid and dissipates heat,
a vapor pipe (3)
which conveys the gas-phase refrigerant to the condensing unit, and
a liquid pipe (4)
which conveys a liquid-phase refrigerant obtained by condensing the gas-phase refrigerant in the condensing unit to the evaporation unit, wherein
the condensing unit includes a heat dissipation flow path (7), an upper header (5)
which
10 connects the vapor pipe and the heat dissipation flow path, and a lower header (6)
which
connects the heat dissipation flow path and the liquid pipe,
the upper header includes a flow path header portion (5a)
connected to the heat
dissipation flow path and an upper header extension portion (5b)
connected to the flow path
header portion,
15 the upper header extension portion has a connection port (20)
connected to the vapor
pipe in a lower surface part of the upper header to which the heat dissipation flow path is connected, and the vapor pipe connects an upper part of the evaporation unit, **characterised in that**
the liquid pipe connects a side surface part of the evaporation unit and the lower header.

2. The cooling device described in claim 1 **characterized in that** a width of the upper header extension portion in a direction from the connection port toward the flow path header and a width thereof in a vertical direction are approximately equal to a width of the flow path header portion in a direction from the connection port toward the flow 25 path header and a width thereof in a vertical direction, respectively.

3. The cooling device described in claim 1 **characterized in that** the width of the upper header extension portion in the direction from the connection port toward the flow path header and the width thereof in the vertical direction are smaller than the width of the flow path header portion in the direction from the connection port toward the flow path header and the width thereof in the vertical direction, respectively.

4. The cooling device described in any one of claim 1 to claim 3 **characterized in** 5 that a cross-sectional area of the upper header extension portion in the direction from the connection port toward the flow path header and a cross-sectional area thereof in the vertical direction are greater than the cross-sectional area of the vapor pipe.

5. The cooling device described in any one of claim 1 to claim 4 **characterized in that** a length of the upper header extension portion in the direction from the connection port toward the flow path header is smaller than the length of the vapor pipe in the vertical direction.

6. The cooling device described in any one of claim 1 to claim 5 **characterized in that** the cooling device includes a plurality of the vapor pipes and the evaporation unit is connected to the upper header by a plurality of the vapor pipes.

7. The cooling device described in any one of claim 1 to claim 6 **characterized in that**
the condensing unit is composed of a plurality of the heat dissipation flow paths and
the vapor pipe is disposed in a direction perpendicular to a direction in which a plurality of the heat dissipation flow paths are disposed in parallel,

8. The cooling device described in any one of claim 1 to claim 6 **characterized in that**
the condensing unit is composed of a plurality of the heat dissipation flow paths and
the vapor pipe is disposed in line approximately parallel to the direction in which a plurality of the heat dissipation flow paths are disposed in parallel.

9. The cooling device described in any one of claim 1 to claim 8 **characterized in that** the vapor pipe is extended in a straight line shape in a vertical direction.

10. The cooling device described in any one of claim 1 to claim 9 **characterized in that**
the cooling device includes a plurality of the heat dissipation flow paths,
a heat dissipation fin is disposed in between a plurality of the adjacent heat 10 dissipation flow paths, and
the heat dissipation fin is thermally connected to the heat dissipation flow path.

11. The cooling device described in any one of claim 1 to claim 10 **characterized in that** one of the vapor pipe and the liquid pipe has a structure in which an inner layer is a 15 metal layer and an outer layer is a resin layer.

## Patentansprüche

1. Kühlvorrichtung, die aufweist:
eine Verdampfungseinheit (1), die ein Kühlmittel speichert,
eine Kondensationseinheit (2), die ein durch Verdampfen des Kühlmittels in der Verdampfungseinheit erzeugtes Gasphasenkühlmittel zu einer Flüssigkeit kondensiert und Wärme abführt,
eine Dampfleitung (3), die das Gasphasenkühlmittel zur Kondensationseinheit befördert, und
eine Flüssigkeitsleitung (4), die ein durch Kondensieren des Gasphasenkühlmittels in der Kondensationseinheit erhaltenes Flüssigkeitsphasenkühlmittel zur Verdampfungseinheit befördert, wobei
die Kondensationseinheit einen Wärmeabführungsdurchflussweg (7), einen oberen Verteiler (5), der die Dampfleitung und den Wärmeabführungsdurchflussweg verbindet, und einen unteren Verteiler (6) aufweist, der den Wärmeabführungsdurchflussweg und die Flüssigkeitsleitung verbindet,
der obere Verteiler einen Durchflusswegverteilerabschnitt (5a), der mit dem Wärmeabführungsdurchflussweg verbunden ist, und einen Erweiterungsabschnitt (5b) des oberen Verteilers aufweist, der mit dem Durchflusswegverteilerabschnitt verbunden ist,
der Erweiterungsabschnitt des oberen Verteilers einen Verbindungsanschluss (20) aufweist, der mit der Dampfleitung in einem unteren Flächenteil des oberen Verteilers verbunden ist, an dem der Wärmeabführungsdurchflussweg angeschlossen ist, und
die Dampfleitung einen oberen Teil der Verdampfungseinheit verbindet, **dadurch gekennzeichnet, dass**
die Flüssigkeitsleitung ein Seitenflächenteil der Verdampfungseinheit und den unteren Verteiler verbindet.

2. Kühlvorrichtung nach Anspruch 1, **dadurch gekennzeichnet, dass** eine Breite des Erweiterungsabschnitts des oberen Verteilers in eine Richtung vom Verbindungsanschluss zum Durchflusswegverteiler und dessen Breite in eine vertikale Richtung annähernd gleich einer Breite des Durchflusswegverteilerabschnitts in eine Richtung vom Verbindungsanschluss zum Durchflusswegverteiler bzw. dessen Breite in eine vertikale Richtung sind.

3. Kühlvorrichtung nach Anspruch 1, **dadurch gekennzeichnet, dass** die Breite des Erweiterungsabschnitts des oberen Verteilers in die Richtung vom Verbindungsanschluss zum Durchflusswegverteiler und dessen Breite in die vertikale Richtung kleiner als die Breite des Durchflusswegverteilerabschnitts in die Richtung vom Verbindungsanschluss zum Durchflusswegverteiler bzw. dessen Breite in die vertikale Richtung sind.

4. Kühlvorrichtung nach einem der Ansprüche 1 bis 3, **dadurch gekennzeichnet, dass** eine Querschnittsfläche des Erweiterungsabschnitts des oberen Verteilers in die Richtung vom Verbindungsanschluss zum Durchflusswegverteiler und dessen Querschnittsfläche in die vertikale Richtung größer als eine Querschnittsfläche der Dampfleitung sind.

5. Kühlvorrichtung nach einem der Ansprüche 1 bis 4, **dadurch gekennzeichnet, dass** eine Länge des Erweiterungsabschnitts des oberen Verteilers in die Richtung vom Verbindungsanschluss zum Durchflusswegverteiler kleiner als die Länge der Dampfleitung in die vertikale Richtung ist.

6. Kühlvorrichtung nach einem der Ansprüche 1 bis 5, **dadurch gekennzeichnet, dass** die Kühlvorrichtung mehrere der Dampfleitungen aufweist und die Verdampfungseinheit mit dem oberen Verteiler durch mehrere der Dampfleitungen verbunden ist.

7. Kühlvorrichtung nach einem der Ansprüche 1 bis 6, **dadurch gekennzeichnet, dass**
die Kondensationseinheit aus mehreren der Wärmeabführungsdurchflusswege besteht und
die Dampfleitung in eine Richtung angeordnet ist, die senkrecht zu einer Richtung verläuft, in die mehrere der Wärmeabführungsdurchflusswege parallel angeordnet sind.

8. Kühlvorrichtung nach einem der Ansprüche 1 bis 6, **dadurch gekennzeichnet, dass**
die Kondensationseinheit aus mehreren der Wärmeabführungsdurchflusswege besteht und
die Dampfleitung in einer annähernd parallelen Linie zu der Richtung angeordnet ist, in die mehrere der Wärmeabführungsdurchflusswege parallel angeordnet sind.

9. Kühlvorrichtung nach einem der Ansprüche 1 bis 8, **dadurch gekennzeichnet, dass** sich die Dampfleitung in einer geraden Linie in eine vertikale Richtung erstreckt.

10. Kühlvorrichtung nach einem der Ansprüche 1 bis 9, **dadurch gekennzeichnet, dass** die Kühlvorrichtung mehrere der Wärmeabführungsdurchflusswege aufweist,
eine Wärmeabführungsrippe zwischen mehreren benachbarten Wärmeabführungsdurchflusswegen angeordnet ist, und
die Wärmeabführungsrippe thermisch mit dem Wärmeabführungsdurchflussweg verbunden ist.

11. Kühlvorrichtung nach einem der Ansprüche 1 bis 10, **dadurch gekennzeichnet, dass** eine der Dampfleitung und der Flüssigkeitsleitung einen Aufbau aufweist, in dem eine Innenschicht eine Metallschicht ist und eine Außenschicht eine Harzschicht ist.

## Revendications

1. Dispositif de refroidissement, comprenant :
une unité d'évaporation (1) qui stocke un fluide frigorigène,
une unité de condensation (2) qui condense en liquide un fluide frigorigène en phase gazeuse produit par évaporation du fluide frigorigène dans l'unité d'évaporation et dissipe la chaleur,
un tuyau de vapeur (3) qui transporte le fluide frigorigène en phase gazeuse vers l'unité de condensation, et
un tuyau de liquide (4) qui transporte vers l'unité d'évaporation un fluide frigorigène en phase liquide obtenu par condensation du fluide frigorigène en phase gazeuse dans l'unité de condensation, où
l'unité de condensation comprend un passage de dissipation de chaleur (7), un collecteur supérieur (5) reliant le tuyau de vapeur au passage de dissipation de chaleur, et un collecteur inférieur (6) reliant le passage de dissipation de chaleur au tuyau de liquide,
le collecteur supérieur comprend une partie (5a) de passage de collecteur reliée au passage de dissipation de chaleur et une partie (5b) d'extension de collecteur supérieur reliée à la partie de passage de collecteur,
la partie d'extension de collecteur supérieur comporte un orifice de connexion (20) relié au tuyau de vapeur dans une section de surface inférieure du collecteur supérieur auquel le passage de dissipation de chaleur est relié, et le tuyau de vapeur relie une section supérieure de l'unité d'évaporation, **caractérisé en ce que**
le tuyau de liquide relie une section de surface latérale de l'unité d'évaporation au collecteur inférieur.

2. Dispositif de refroidissement selon la revendication 1, **caractérisé en ce qu'**une largeur de la partie d'extension de collecteur supérieur dans la direction allant de l'orifice de connexion au passage de collecteur et une largeur de celle-ci dans la direction verticale sont sensiblement égales à une largeur de la partie de passage de collecteur dans la direction allant de l'orifice de connexion au passage de collecteur et à une largeur de celle-ci dans la direction verticale, respectivement.

3. Dispositif de refroidissement selon la revendication 1, **caractérisé en ce que** la largeur de la partie d'extension de collecteur supérieur dans la direction allant de l'orifice de connexion au passage de collecteur et la largeur de celle-ci dans la direction verticale sont inférieures à la largeur de la partie de passage de collecteur dans la direction allant de l'orifice de connexion au passage de collecteur et à la largeur de celle-ci dans la direction verticale, respectivement.

4. Dispositif de refroidissement selon l'une des revendications 1 à 3, **caractérisé en ce qu'**une surface de section transversale de la partie d'extension de collecteur supérieur dans la direction allant de l'orifice de connexion au passage de collecteur et une surface de section transversale de celle-ci dans la direction verticale sont supérieures à la surface de section transversale du tuyau de vapeur.

5. Dispositif de refroidissement selon l'une des revendications 1 à 4, **caractérisé en ce qu'**une longueur de la partie d'extension de collecteur supérieur dans la direction allant de l'orifice de connexion au passage de collecteur est inférieure à la longueur du tuyau de vapeur dans la direction verticale.

6. Dispositif de refroidissement selon l'une des revendications 1 à 5, **caractérisé en ce que** ledit dispositif de refroidissement comprend une pluralité de tuyaux de vapeur et **en ce que** l'unité d'évaporation est reliée au collecteur supérieur par une pluralité de tuyaux de vapeur.

7. Dispositif de refroidissement selon l'une des revendications 1 à 6, **caractérisé en ce que** l'unité de condensation est composée d'une pluralité de passages de dissipation de chaleur et **en ce que** le tuyau de vapeur est disposé suivant une direction perpendiculaire à une direction où une pluralité de passages de dissipation de chaleur sont disposés en parallèle.

8. Dispositif de refroidissement selon l'une des revendications 1 à 6, **caractérisé en ce que** l'unité de condensation est composée d'une pluralité de passages de dissipation de chaleur, et **en ce que** le tuyau de vapeur est disposé sur une ligne sensiblement parallèle à la direction où une pluralité de passages de dissipation de chaleur sont disposés en parallèle.

9. Dispositif de refroidissement selon l'une des revendications 1 à 8, **caractérisé en ce que** le tuyau de vapeur s'étend en ligne droite dans la direction verticale.

10. Dispositif de refroidissement selon l'une des revendications 1 à 9, **caractérisé en ce que** ledit dispositif de refroidissement comprend une pluralité de passages de dissipation de chaleur,
une ailette de dissipation de chaleur est disposée entre une pluralité de passages de dissipation de chaleur adjacents, et **en ce que**
l'ailette de dissipation de chaleur est thermiquement reliée au passage de dissipation de chaleur.

11. Dispositif de refroidissement selon l'une des revendications 1 à 10, **caractérisé en ce que** le tuyau de vapeur, ou le tuyau de liquide a une structure où une couche intérieure est une couche métallique, et une couche extérieure est une couche de résine.
